# EUROPEAN PATENT APPLICATION

(11) **EP 1 453 099 A2**
(43) Date of publication of application: **01.09.2004**
(21) Application number: 04392008.1
(22) Date of filing: 24.02.2004
(51) Int. Cl.: H01L 27/142

(54) **Vertical charge transfer active pixel sensor**

(30) Priority: 26.02.2003 US 450089 P
(71) Applicant: Dialog Semiconductor, Clinton, New Jersey 08809 (US)
(72) Inventor: Taner, Dosluoglu, New York, NY 10011 (US)
(74) Representative: Schuffenecker, Thierry

(57) **Abstract**

An active pixel sensor comprising an N well of n type silicon formed in a p type silicon substrate and a P well of p type silicon is formed in the N well. A deep N well is formed of n type silicon underneath the P well. The edges of the deep N well contact the bottom of the N well forming an overlap region which can either be not depleted of charge carriers thereby electrically connecting the N well to the deep N well or depleted of charge carriers thereby electrically isolating the N well from the deep N well. N regions formed in the P well and P regions formed in the N well are used to reset the pixel and to read the pixel after a charge integration period. An array of P wells formed within N wells can be used to form an array of active pixel sensors. In this array an overlap region is formed between each N well and the deep N well. In an array of active pixel sensors the N regions can be binned together by using the overlap regions to connect each N well to the deep N well thereby achieving noise suppression during the reset cycle.

## Description

### Technical field

This invention relates to an active pixel sensor using a deep N well or P well to achieve vertical charge transfer.

### Background art

U.S. Pat. No. 6,501,109 to Chi describes an active CMOS pixel sensor with a p well within a deep n well.

U.S. Pat. No. 6,001,667 to Saitoh et al. describes a method of manufacturing a semiconductor detector for detecting light radiation showing a p well within a deep n well.

U.S. Pat. No. 5,600,127 to Kimata describes vertical charge transfer using an n well.

U.S. Pat. No. 5,210,433 to Ohsawa et al. describes a solid state CCD imaging device showing a potential well and a deep potential well for vertical charge transfer.

U.S. Pat. No. 5,040,038 to Yutani et al. describes a solid state image sensor showing a transfer potential well under a transfer electrode.

U.S. Pat. No. 4,875,101 to Endo et al. describes a solid state imaging device showing shallow and deep potential wells for vertical charge transfer.

### Summary of the invention

It is the objective of this invention to provide an Active Pixel Sensor structure which can control vertical charge transfer.

This objective is achieved using a deep well structure. A silicon substrate having an epitaxial layer of p type silicon is provided. An N well of n type silicon is formed wherein the N well surrounds an island of p type silicon. A deep N well is formed of n type silicon underneath the island of p type silicon thereby forming a P well of p type silicon. The P well is within the boundaries of the N well and above the deep N well. The edges of the deep N well contact the bottom of the N well forming an overlap region which can either electrically connect the N well to the deep N well or electrically isolate the N well from the deep N well. N regions formed in the P well and P regions formed in the N well are used to reset the pixel and to read the pixel after a charge integration period. The overlap region can be used to connect the N well to the deep N well so that carriers generated in the deep N well can be transferred to the N well. The overlap region can also be depleted to isolate the N well from the deep N well so that charges transferred from the deep N well to the N well can be stored in the N well.

Alternatively, a silicon substrate having an epitaxial layer of n type silicon is provided. A P well of p type silicon is formed wherein the P well surrounds an island of n type silicon. A deep P well is formed of p type silicon underneath the island of n type silicon thereby forming an N well of n type silicon. The N well is within the boundaries of the P well and above the deep P well. The edges of the deep P well contact the bottom of the P well forming an overlap region which can either electrically connect the P well to the deep P well or electrically isolate the P well from the deep P well. P regions formed in the N well and N regions formed in the P well are used to reset the pixel and to read the pixel after a charge integration period. The overlap region can be used to connect the P well to the deep P well so that carriers generated in the deep P well can be transferred to the P well. The overlap region can be depleted to isolate the P well from the deep P well so that charges transferred from the deep P well to the P well can be stored in the P well.

### Description of the drawings

Fig. 1 shows a cross section view of the active pixel sensor of this invention.
Fig. 2 shows a top view of the active pixel sensor of this invention.
Fig. 3 shows a cross section view of two pixels joined by a single deep N well or deep P well.
Fig. 4 shows a top view of a portion of an array of active pixel sensors of this invention.
Fig. 5 shows a cross section view top view of a portion of an array of active pixel sensors of this invention.

### Description of the preferred embodiments

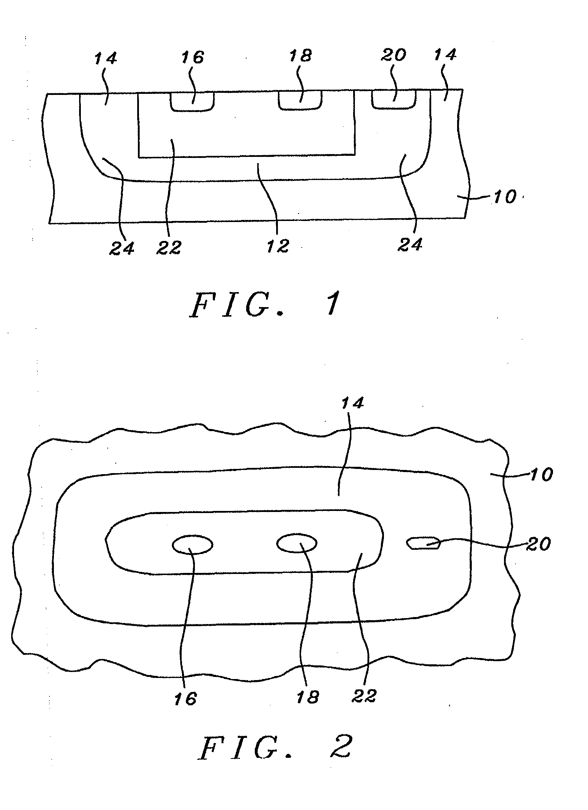

Fig. 1 shows a cross section view of the Active Pixel Sensor of this invention. In the first embodiment an N well 14 of n type silicon is formed in a p type epitaxial silicon substrate 10. A deep N well 12 is formed a distance below the surface of the substrate 10 thereby forming a P well 22 within the N well 14 and above the deep N well 12. A overlap region 24 connects the N well 14 and the deep N well 12. The overlap region 24 is designed such that the overlap region 24 will be depleted or not depleted depending on the potential of the P Well 22. A first N region 16 and a second N region 18 are formed in the P well 22. A P region 20 is formed in the N well 14.

In the operation of the pixel the N well 14 is set at a reset voltage and the P well 22 is set at a positive potential so that the overlap region 24 is not depleted. This sets the potential of the deep N well 22 at the same potential as the N well 14. The potential of the P well is then set to a negative potential so that the overlap region 24 is depleted. This isolates the deep N 12 well during the charge integration period. After the charge integration period has been completed the potential of the P well 22 is set to a positive potential, the overlap region 24 is not depleted, and the charge accumulated by the deep N well 12 is transferred to the N well. The potential of the P well 22 can be adjusted to adjust the amount of depletion of the overlap region 24 and thereby control the charge transfer to the N well 14.

In one mode of operation the potential of the N well 14 can be read before and after the transfer of the charge from the deep N well 12 to the N well 14 providing a pixel correlated double sampling operation.

The charge transfer from the deep N well 12 to the N well 14 is primarily determined by the P well 12 potential and the N well 14 potential. In another mode of operation the P well 22 could be left floating and the charge transfer would be controlled by adjusting the potential of the N well 14. In this case the P well 22 will be used in a manner similar to a floating gate sense node and the signal can be readout prior to, during, and after the charge transfer from the deep N well 12 to the N well 14.

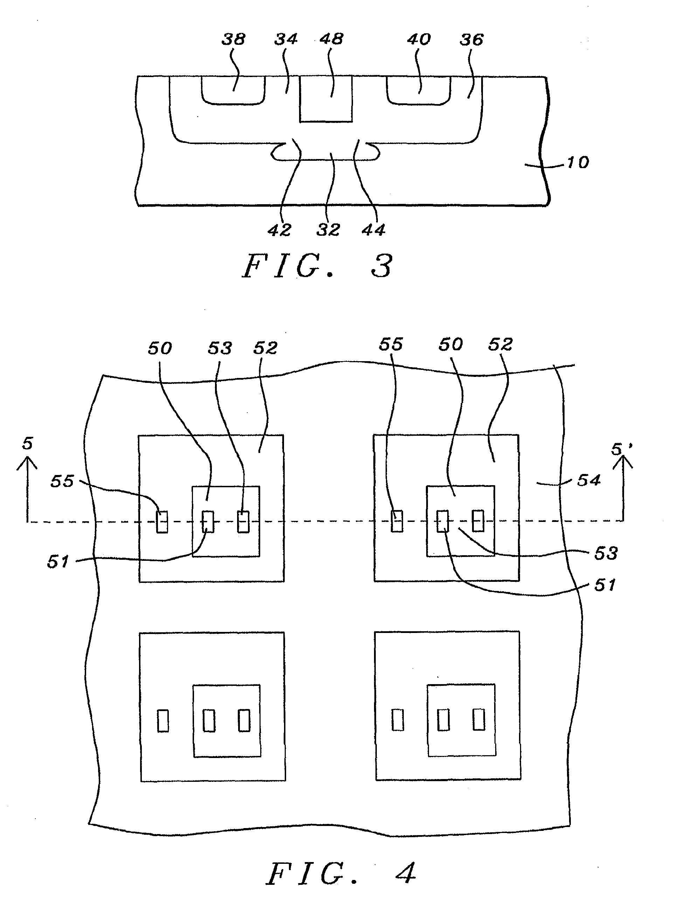

The previous example showed a single P well 22 formed in a single N well 14 with a deep N well 12. An overlap region 24 provides communication or isolation between the N well 14 and deep N well. A number of N wells with a single deep N well can be used, having a P well formed in each of the N wells, and depletion regions to provide communication or isolation between each of the N wells and the deep N well. Fig. 3 shows a structure having two N wells, a first N well 34 and a second N well 36, having overlap regions connecting both N wells to the same deep N well 32. A P region 48 separates the two N wells. The first N well 34 is connected to the deep N well 32 by a first overlap region 42. The second N well 36 is connected to the deep N well 32 by a second overlap region 44. There is a first P well 38 in the first N well 34 and a second P well 40 is the second N well 36. The overlap regions, 42 and 44, are designed to allow depletion of the first overlap region 42 while the second overlap region 44 is not depleted, depletion of the second overlap region 44 while the first overlap region 42 is not depleted, depletion of both overlap regions, or leaving both overlap regions not depleted. During reset neither the first overlap region 42 nor the second overlap region 44 are depleted and the first N well 34, the second N well 36, and the deep N well 32 are set to the same potential. This will reduce the kTC noise during reset. Binning of the first N well 34 and the second N well 36 can be accomplished by adjusting the potentials so that neither the first overlap region 42 nor the second overlap region 44 are depleted.

In the structures shown in Figs. 1 and 3, sufficiently high voltage is applied to deplete the overlap regions; 24 in Fig. 1, and 42 and 44 in Fig. 3; during the charge integration period. After the integration period has been completed, charge transfer can be controlled by controlling the amount of depletion in the overlap regions; 24 in Fig. 1, and 42 and 44 in Fig. 3. In the structure shown in Fig. 3, the overlap regions, 42 and 44, can be turned on (not depleted) during the reset operation to connect the N well regions, 36 and 38, to achieve reset noise suppression and turned off (depleted) after reset to isolate the N well regions, 36 and 38. In the structure shown in Fig. 3, the overlap regions, 42 and 44, can be turned on (not depleted) to connect adjacent N wells, 34 and 36, to achieve binning. In the structures shown in Figs. 1 and 3 the P well regions, 22 in Fig. 1 and 38 and 40 in Fig. 3, can be used as a floating gate sense node for alternative non-destructive readout.

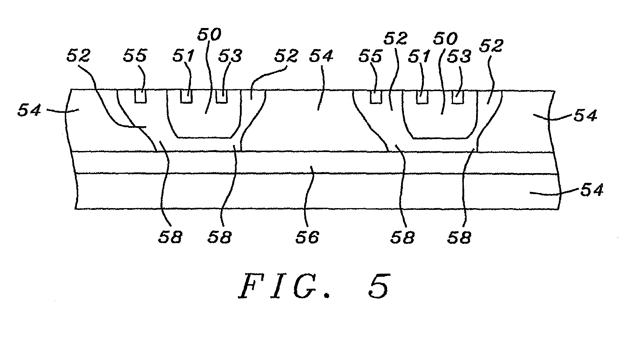

The above description has shown two N wells 34 and 36 which communicate by a single deep N well 32. As indicated above, a structure having a greater number of N wells and a single deep N well can also be used. In this case the N wells communicate to a single deep N well by means of a number of overlap regions. Fig. 4 shows a top view and Fig. 5 shows a cross section view, taken along line 5-5' of Fig. 4, of an array of N wells 50 formed in a p type substrate 54 with a P well 50 in each of the N wells 52. A deep N well 56 in formed in the substrate 54 extending beneath each of the P wells 50. An overlap region 58 is formed between each of the N wells 52 and the deep N well 56. A first N region 51 and a second N region 53 are formed in each P well 50. A P region 55 is formed in each N well 52. In this case a sufficiently high voltage is applied to deplete all of the overlap regions 58 during the charge integration period. After the charge integration period has been completed, charge transfer can be controlled by controlling the amount of depletion in each of the overlap regions 58. The overlap regions 58 can then be turned on during the reset operation to connect the individual N wells 52 together, thereby achieving reset noise suppression. The overlap regions 58 will then be turned off after reset to isolate the N wells 52 for the next charge accumulation cycle. In this structure the overlap regions 58 are turned on to interconnect the N wells to achieve binning.

The overlap regions 58 are turned on during the reset cycle. The overlap regions 58 are then turned on during the charge integration period. After the completion of the charge integration period the overlap regions 58 can be used to control the charge transfer from the deep N well 56 to each of the N wells 52. The pixel is read by reading the potential of the N wells 56. In one mode of operation the potential of the N wells 56 can be read before and after the transfer of the charge from the deep N well 56 to each N well 56 providing a pixel correlated double sampling operation. The first 51 and second 53 N regions in each of the P wells 50 provide electrical communication to each of the P wells 50. The P region in each of the N wells 52 provide electrical communication to each of the N wells 52. The first N region 51, second N region 53, and P well 50 in each N well 52 can be used as a floating gate field effect transistor. In this structure P well regions 50 formed in each of the N wells 52 can be used as a floating gate sense node for alternative non-destructive readout.

Those skilled in the art will readily recognize that the invention will also work using a deep P well in an n type epitaxial silicon substrate. In this case n regions are replaced by p regions, p regions are replaced by n regions positive potentials are replaced by negative potentials, and negative potentials are replaced by positive potentials.

While the invention has been particularly shown and described with reference to the preferred embodiments thereof, it will be understood by those skilled in the art that various changes in form and details may be made without departing from the spirit and scope of the invention.

## Claims

1. An active pixel sensor, comprising:
- a p type epitaxial silicon substrate;
- an N well formed in said substrate;
- a P well formed in said N well;
- a deep N well formed in said substrate beneath said P well;
- an overlap region formed between said N well and said deep N well wherein said overlap region electrically connects said N well to said deep N well when said overlap region is not depleted of charge carriers and electrically isolates said N well from said deep N well when said overlap region is depleted of charge carriers;
- a first N region and a second N region formed in said P well; and
- a P region formed in said N well.

2. The active pixel sensor of claim 1 wherein said first N region and said second N region provide electrical communication to said P well and said P region provides electrical communication to said N well.

3. The active pixel sensor of claim 1 wherein the potential of said P well and the potential of said N well determine whether or not said overlap region is depleted of charge carriers or is not depleted of charge carriers.

4. The active pixel sensor of claim 1 wherein said first N region, said second N region, and said P well can be used to form a floating gate field effect transistor.

5. The active pixel sensor of claim 1 wherein the potential of said P well is set so that said overlap region is depleted of charge carriers during a charge integration period.

6. The active pixel sensor of claim 1 wherein the potential of said P well is set so that said overlap region is not depleted of charge carriers after a charge integration period has been completed.

7. The active pixel sensor of claim 1 wherein the potential of said P well is set so that said overlap region is not depleted of charge carriers after a charge integration period has been completed and said first N region, said second N region, and said P well are used as a floating gate field effect transistor.

8. An array if active pixel sensors comprising:
- a p type epitaxial silicon substrate;
- a number of N wells formed in said substrate;
- a P well formed in each of said N wells;
- a deep N well formed in said substrate wherein said deep N well extends beneath each of said P wells;
- an overlap region formed between each of said N wells and said deep N well wherein said each of said overlap regions electrically connects one of said N wells to said deep N well when that said overlap region between that said N well and said deep N well is not depleted of charge carriers and electrically isolates one of said N wells from said deep N well when that said overlap region between that said N well and said deep N well is not depleted of charge carriers;
- a first N region and a second N region formed in each of said P wells; and
- a P region formed in each of said N wells.

9. The array of claim 8 wherein said first N region and said second N region in each of said P wells provide electrical communication to that said P well.

10. The array of claim 8 wherein said P region formed in each of said N wells provides electrical communication to that said N well.

11. The array of claim 8 wherein for each of said N wells the potential of that said N well and the potential of said P well in that said N well determines whether or not said overlap region between that said N well and said deep N well is depleted of charge carriers or is not depleted of charge carriers.

12. The array of claim 8 wherein for each of said N wells said P well in that said N well, said first N region in said P well in that said N well, and said second N region in said P well in that said N well can be used to form a floating gate field effect transistor in that said N well.

13. The array of claim 8 wherein the potentials of each of said P wells are set so that said overlap regions between each of said N wells and said deep N well are not depleted of charge carriers during a reset cycle.

14. The array of claim 8 wherein a selected group of said N wells can be binned together by setting the potentials of each of said P wells in said selected group of said N wells so that said overlap regions between each of said N wells in said selected group of said N wells and said deep N well are not depleted of charge.

15. The array of claim 8 wherein the potentials of each of said P wells are set so that said overlap regions between each of said N wells and said deep N well are depleted of charge carriers during a charge integration cycle.

16. The array of claim 8 wherein the potentials of each of said P wells are set so that said overlap regions between each of said N wells and said deep N well are not depleted of charge carriers after a charge integration cycle has been completed.

17. The array of claim 8 wherein the potentials of each of said P wells are set so that said overlap regions between each of said N wells and said deep N well are not depleted of charge carriers after a charge integration cycle has been completed and said first N region, said second N region, and said P well in each of said N wells are used as a floating gate field effect transistor.

18. An active pixel sensor, comprising:
- an n type epitaxial silicon substrate;
- a P well formed in said substrate;
- an N well formed in said P well;
- a deep P well formed in said substrate beneath said N well;
- an overlap region formed between said P well and said deep P well wherein said overlap region electrically connects said P well to said deep P well when said overlap region is not depleted of charge carriers and electrically isolates said P well from said deep P well when said overlap region is depleted of charge carriers;
- a first P region and a second P region formed in said N well; and
- an N region formed in said P well.

19. The active pixel sensor of claim 18 wherein said first P region and said second P region provide electrical communication to said N well and said N region provides electrical communication to said P well.

20. The active pixel sensor of claim 18 wherein the potential of said N well and the potential of said P well determine whether or not said overlap region is depleted of charge carriers or is not depleted of charge carriers.

21. The active pixel sensor of claim 18 wherein said first P region, said second P region, and said N well can be used to form a floating gate field effect transistor.

22. The active pixel sensor of claim 18 wherein the potential of said N well is set so that said overlap region is depleted of charge carriers during a charge integration period.

23. The active pixel sensor of claim 18 wherein the potential of said N well is set so that said overlap region is not depleted of charge carriers after a charge integration period has been completed.

24. The active pixel sensor of claim 18 wherein the potential of said N well is set so that said overlap region is not depleted of charge carriers after a charge integration period has been completed and said first P region, said second P region, and said N well are used as a floating gate field effect transistor.

25. An array if active pixel sensors comprising:
- an n type epitaxial silicon substrate;
- a number of P wells formed in said substrate;
- an N well formed in each of said P wells;
- a deep P well formed in said substrate wherein said deep P well extends beneath each of said N wells;
- an overlap region formed between each of said P wells and said deep P well wherein said each of said overlap regions electrically connects one of said P wells to said deep P well when that said overlap region between that said P well and said deep P well is not depleted of charge carriers and electrically isolates one of said P wells from said deep P well when that said overlap region between that said P well and said deep P well is not depleted of charge carriers;
- a first P region and a second P region formed in each of said N wells; and
- an N region formed in each of said P wells.

26. The array of claim 25 wherein said first P region and said second P region in each of said N wells provide electrical communication to that said N well.

27. The array of claim 25 wherein said P region formed in each of said P wells provides electrical communication to that said P well.

28. The array of claim 25 wherein for each of said P wells the potential of that said P well and the potential of said N well in that said P well determines whether or not said overlap region between that said P well and said deep P well is depleted of charge carriers or is not depleted of charge carriers.

29. The array of claim 25 wherein for each of said P wells said N well in that said P well, said first P region in said N well in that said P well, and said second P region in said N well in that said P well can be used to form a floating gate field effect transistor in that said P well.

30. The array of claim 25 wherein the potentials of each of said N wells are set so that said overlap regions between each of said P wells and said deep P well are not depleted of charge carriers during a reset cycle.

31. The array of claim 25 wherein a selected group of said P wells can be binned together by setting the potentials of each of said N wells in said selected group of said P wells so that said overlap regions between each of said P wells in said selected group of said P wells and said deep P well are not depleted of charge.

32. The array of claim 25 wherein the potentials of each of said N wells are set so that said overlap regions between each of said P wells and said deep P well are depleted of charge carriers during a charge integration cycle.

33. The array of claim 25 wherein the potentials of each of said N wells are set so that said overlap regions between each of said P wells and said deep P well are not depleted of charge carriers after a charge integration cycle has been completed.

34. The array of claim 25 wherein the potentials of each of said N wells are set so that said overlap regions between each of said P wells and said deep P well are not depleted of charge carriers after a charge integration cycle has been completed and said first P region, said second P region, and said N well in each of said P wells are used as a floating gate field effect transistor.
